# EUROPEAN PATENT APPLICATION

(11) **EP 1 441 043 A2**
(43) Date of publication of application: **28.07.2004**
(21) Application number: 03256470.0
(22) Date of filing: 14.10.2003
(51) Int. Cl.: C23C 16/44, H01L 21/00, B08B 7/00

(54) **Supply of gas to semiconductor process chamber**

(30) Priority: 18.10.2002 US 274250
(71) Applicant: THE BOC GROUP, INC., Murray Hill, New Providence, New Jersey 07974 (US)
(72) Inventor: McFarlane, Graham Anthony, Murrieta CA 92563 (US); Hodgson, Graham, Poulton-le-Fylde Lancashire, FU6 7HQ (GB); Buckley, Peter Harold, Salem NH 03079 (US); Hogle, Richard Allen, Oceanside CA 92056 (US)
(74) Representative: Booth, Andrew Steven

(57) **Abstract**

A method of for removing residue from a surface of a semiconductor process chamber the method comprising the steps of:
(a) storing a gas at sub-atmospheric pressure in a storage vessel;
(b) removing said gas from said storage vessel under a vacuum; and
(c) passing said gas through a process chamber to be cleaned.

## Description

The present invention relates generally to a method of and a system for supplying gas to a semiconductor process chamber. In its preferred embodiments, the present invention relates to a method of and a system for supplying gas to clean a semiconductor process chamber, where the gas is stored under sub-atmospheric conditions.

A primary step in the fabrication of semiconductor devices is the formation of a thin film on a semiconductor substrate by chemical reaction of vapor precursors. A typical deposition process includes chemical vapor deposition (CVD). Conventional thermal CVD processes supply reactive gases to the substrate surface where heat-induced chemical reactions take place to form a thin film layer over the surface of the substrate being processed.

However, deposition occurs throughout the chamber, and not just on the substrate. The heaviest depositions occur in the hottest areas of the chamber, which is typically in the area of the substrate, but some deposition occurs in other areas, even fairly cool areas or areas not directly exposed to the vapor precursors.

These depositions can cause a number of problems, such as, clogging fine holes in gas nozzles, disrupting an even flow of gas and affecting process uniformity, and clouding chamber windows affecting the ability to see into the chamber. In addition, they may form particulates, which can fall on the substrate and cause a defect in the deposited layer or interfere with the mechanical operation of the deposition system.

To avoid such problems, the inside surface of the chamber is cleaned regularly to remove the unwanted deposition material from the chamber walls and similar areas of the processing chamber. Such cleaning procedures are commonly performed between deposition steps for every wafer or every n wafers. One type of procedure involves disassembling the chamber and cleaning each part using a solution or solvent, then drying and reassembling the system. This procedure is labor-intensive and time-consuming, reducing wafer fabrication line efficiency and increasing costs.

In another cleaning procedure, molecular fluorine (F2) and chlorine trifluoride (ClF3) are examples of gases that have been employed as etchant gases in cleaning operations. Molecular fluorine is a highly corrosive and dangerous gas that requires special handling measures. Most systems require a relatively constant supply pressure to operate effectively. Therefore, the fluorine is stored under positive pressure to accommodate this requirement. One major drawback with this type of pressurized system is that should a leak in the vessel holding the fluorine occur, the fluorine gas would leak out of the vessel into the surrounding atmosphere.

The present invention provides a method of removing residue from a surface of a semiconductor process chamber. The method includes the steps of:
(a) storing a gas at sub-atmospheric pressure in a storage vessel;
(b) removing the gas from the storage vessel under a vacuum; and
(c) passing the gas through a process chamber to be cleaned.

The cleaning gas may be passed through the process chamber with or without a remote plasma source to activate the cleaning gas. In one embodiment, a filtration bed is provided. The cleaning gas is passed through the filtration bed to remove undesirable impurities and purify the cleaning gas. The purified cleaning gas is then flowed to the process chamber to be cleaned.

The cleaning gas may be recycled for re-use following cleaning of the process chamber. Thus, the present invention also provides a recycle process for removing residue from a surface of a semiconductor processing chamber. The recycle process includes the steps of:
(a) storing a gas at sub-atmospheric pressure in a storage vessel;
(b) removing the gas from the storage vessel under a vacuum;
(c) passing the gas through at least one filtration bed, thereby purifying the gas;
(d) conveying the gas to a process chamber to be cleaned, thereby cleaning the process chamber; and
(e) recycling the gas to step (c) for reuse in the cleaning process.

The cleaning gas may be passed through the process chamber with or without a remote plasma source to activate the cleaning gas. The cleaning gas stream removed from the storage vessel may be adjusted to a high concentration at the beginning of the process with the recycled cleaning gas making up a greater volume of the flow in the latter stages of the cleaning process. As a result, less cleaning gas from the storage vessel is required in the latter stages of the cleaning process.

The present invention also provides a system for removing residue from a surface of a semiconductor process chamber. The system includes:
at least one vessel for storing a gas for cleaning the chamber; and
at least one vacuum pump for drawing the cleaning gas from said at least one vessel.

The cleaning gas is stored in the at least one vessel at a pressure in the range from approximately 1.33mbar (about 1 torr) to approximately 1 bar (about 750 torr).

The present invention also provides a recycle system for removing residue from a surface of a semiconductor process chamber. The recycle system includes:
at least one vessel for storing a gas for cleaning the chamber;
at least one vacuum pump for drawing cleaning gas from said at least one vessel; and
at least one filtration/absorption bed for filtering cleaning gas.

The present invention also provides a system for removing residue from a surface of a semiconductor process chamber, the system comprising means for storing a gas at sub-atmospheric pressure in a storage vessel, pump means for drawing the gas from the vessel under a vacuum, and means for conveying the gas from the pump means to a process chamber to be cleaned.

The present invention allows for the versatile operation of process equipment, and especially semiconductor process chamber clean equipment, from any pressure level ranging from a vacuum to about 1 bar (750 torr). The system of the present invention accomplishes this by providing a storage vessel capable of storing gas at sub-atmospheric pressure and a vacuum pump. By using a vacuum pump, the system allows for a vessel to store a reasonable quantity of gas without being pressurized above atmospheric pressure. Therefore, a majority of the capacity of the vessel can be supplied to the process because the vacuum pump pulls the contents from the vessel down to about 1.33mbar (1 torr).

In addition, the gas can be provided at a constant supply pressure, while providing a safe gas storage vessel, since the supply gas is never stored at a pressure above one atmosphere absolute. As a result, any leak in the vessel would result in the contents of the vessel remaining in the vessel with air in the surrounding atmosphere actually leaking into the tank. Therefore, highly reactive and dangerous gases can be stored in the vessel without the fear of the gases leaking out into the surrounding environment.

Another advantage of the present invention is that the cleaning gas can be passed through a process chamber either with or without a remote plasma source to activate the cleaning gas.
Fig. 1 illustrates a sub-atmospheric supply;
Fig. 2 illustrates a sub-atmospheric supply system with a filtration/absorption bed;
Fig. 3 illustrates a sub-atmospheric supply system having a recycle configuration; and
Fig. 4 illustrates another sub-atmospheric supply system having a recycle configuration.

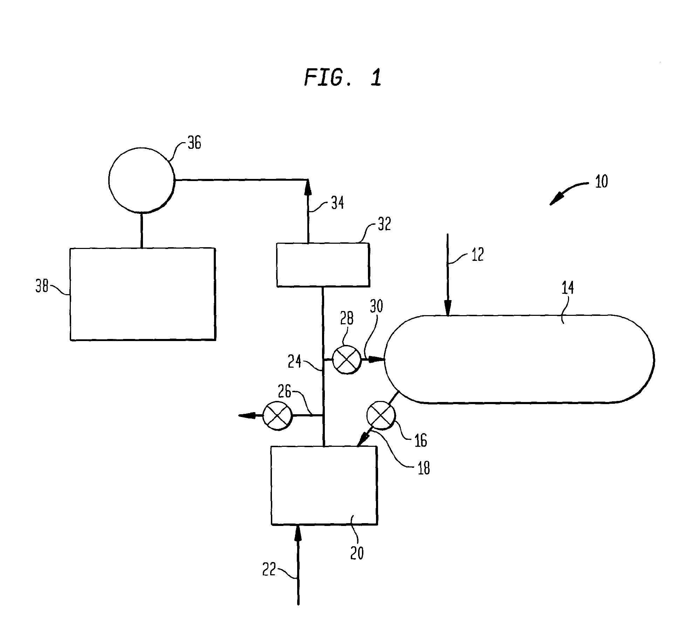

Referring to Fig. 1, a system for cleaning a process chamber is represented generally by reference numeral 10. System 10 has holding tank or vessel 14 designed to hold a cleaning gas for removing residue from a surface of process chamber 38. Suitable cleaning gas includes, but is not restricted to, for example, fluorine, chlorine, ClFx and BrFx, where x=1,3,5, O₂, O₃, NF₃, or any combinations thereof. Preferably, the cleaning gas is fluorine.

The cleaning gas is provided in a volume sufficient to fulfill the needs of an individual cleaning process. By way of example, the volume may be about 4 to about 8 litres, however, the volume will vary depending on the cleaning process to be conducted. The cleaning process may be used to clean process chambers between deposition runs, associated with numerous semiconductor processes, including, for example, CVD of SiO₂, SiNx, W, WSi, Tin, TaN, low-K dielectric coatings, high K dielectric coatings, Si-based photoresists, carbon-based photoresists, or any other deposits that react with fluorine to produce a volatile reaction product.

When the cleaning gas is required, pump 20 pulls the gas stored in vessel 14 via valve 16 and flowline 18 at a rate dictated by mass controller 32 provided downstream of the pump and connected thereto via flowline 24. Pump 20 may be any suitable vacuum pump for flowing a cleaning gas. A pump using Howleck Regenerative Technology with proper surface passivation to resist fluorine attack would be suitable. By way of example, BOC Edwards IPX and EPX model pumps are suitable.

To ensure that there is a positive pressure on the motor housing (not shown) of pump 20, an inert gas is flowed via flowline 22 to the bearing in pump 20 to prevent back flow of cleaning gas into the motor housing. To ensure safety and durability, the inert gas is flowed to the pump housing at a flow rate of at least 1 standard litre/minute. Suitable inert gas includes, for example, argon, helium, N₂, O₂, dry air, or any combinations thereof. The N₂ and O₂ may be used if the etch process is not affected by O₂ or N₂. Preferably, argon gas is used.

To prevent overpressurizing the pump, bypass valve 28 and bypass line 30 are provided so that the cleaning gas can flow back into vessel 14, and avoid excessive back pressure on pump 20. Some dilution of the cleaning gas will occur. Since cleaning gases such as NF₃ are diluted by inert gas in most processes, this dilution would not damage the cleaning process.

The source of the cleaning gas entering vessel 14 via supply line 12 can be from a variety of sources, such as, for example, pressurized cylinder gases or generators. The feed to vessel 14 is designed to keep the pressure between about 0.733 bar (550 torr) to about 1 bar (750 torr) and preferably between about 0.733 bar (550 torr) to about 0.933 bar (700 torr). Pump 20 pulls cleaning gas from vessel 14, as needed. Just before the process starts, pump 20 is activated or alternatively, pump 20 is maintained in a constant operating mode. When the demand of mass controller 32 is required, valve 28 is closed and the flow of cleaning gas is routed through mass controller 32 to remote plasma chamber 36 via flowline 34 until the cleaning gas is no longer needed. Under these conditions, the pressure of the gas in vessel 14 will start at about 0.733 bar (550 torr) to about 1 bar (750 torr) and drop until the demand exceeds the supply, which could result in a pressure as low as 1.33mbar (1 torr). Therefore, should a leak occur in vessel 14 or supply line 12, cleaning gas would not leak to the atmosphere since the vessel is under sub-atmospheric pressure. This results in a safe, leak-proof system. If more gas is accumulated than needed by the process, excess cleaning gas can be vented through line 26.

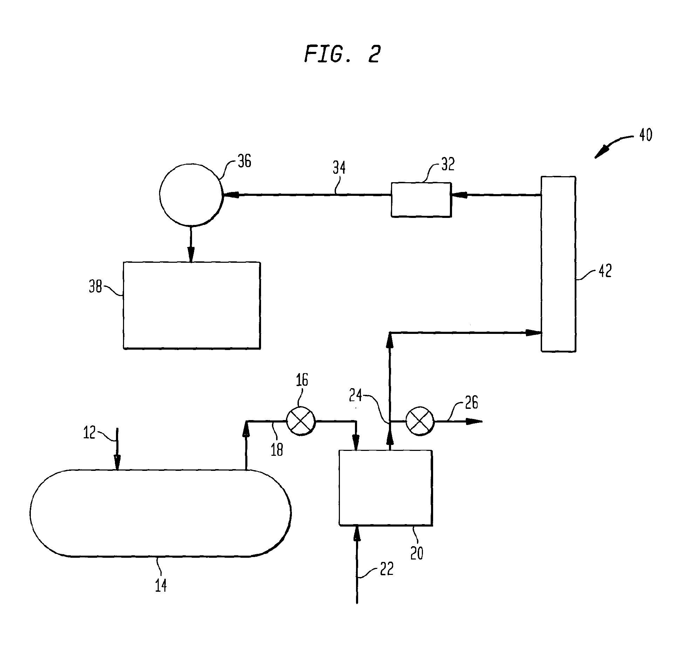

Referring to Fig. 2, a cleaning system with a filtration bed is represented generally by reference numeral 40. System 40 has filtration/absorption bed 42 in addition to the components described above in Fig. 1. Filtration bed 42 could be a combination of CFx pellets, where x = 0.9 to 1.2, NaF, KF, CaF₂, NaHF₂, NaF(HF)_{y}, KF(HF)_{y}, CaF₂(HF)_{y}, where y = 1 to 4, or any combinations thereof, to absorb HF, CF₄, SiF₄, and any other contaminants that could be present in the gas supplied to vessel 14. In this configuration, the filtration bed not only enhances the cleaning gas going to plasma chamber 36, but also allows for the quality of the cleaning gas being supplied to vessel 14 to be less than optimum, therefore reducing costs.

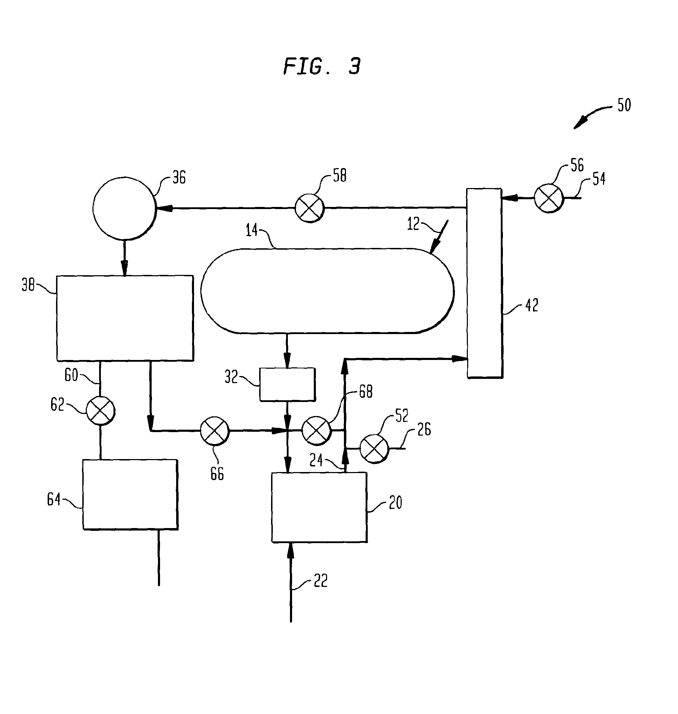

Referring to Fig. 3, a sub-atmospheric system with a recycle configuration is represented generally by reference numeral 50. System 50 has a line from the process chamber 38 that returns the gas to the system for recycle. In the case of fluorine, sixty to eighty percent of the fluorine that enters the chamber in the cleaning process is not used, and is converted back to F₂. Gases that can cause particulate problems in the process chamber (i.e., SiF₄, CF₄, HF) are scrubbed out of the spent cleaning gas leaving process chamber 38 by filtration bed 42. The inert gases, such as, nitrogen and argon can be recycled with the F₂ rich stream, which can then supply the remote plasma chamber 36 with a high concentration of fluorine. This will maximize the actual use of the fluorine.

During the cleaning recycle process, valves 52, 56, 62 and 68 are closed. Valves 58 and 66 are open. Fresh cleaning gas is pulled from vessel 14 through mass flow controller 32 by pump 20. The gas is fed through filtration bed 42 where contaminants are removed from the cleaning gas. The purified cleaning gas is then fed to plasma chamber 36 and ultimately to process chamber 38, where cleaning occurs. The cleaning gas is then pulled from process chamber 38 where it combines with fresh cleaning gas prior to returning to pump 20 for recycle. This recycle process continues until the cleaning process is complete.

The cleaning gas stream is adjusted to a high concentration at the beginning of the process with the recycled cleaning gas taking up a greater extent of the flow at the latter part of the process run. As a result, less fresh cleaning gas is needed in the latter stages of the cleaning process, resulting in cost savings.

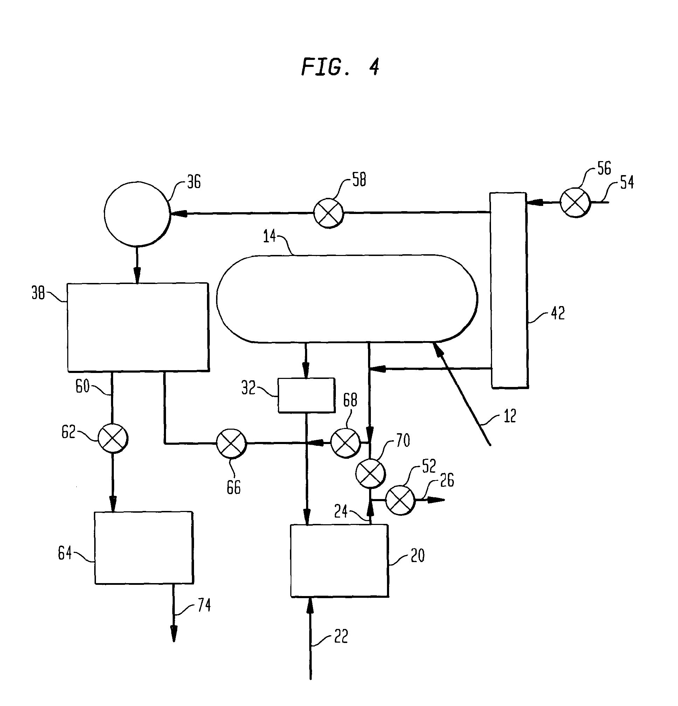

Referring to Fig. 4, when the process chamber in Fig. 3 goes into the process mode, the system is reconfigured into a regeneration mode, as depicted in Fig. 4. In the regeneration mode, valves 58, 66 and 70 are closed. Valves 52, 56 62 and 68 are open. Pump 64 resumes process chamber operations by pulling process gas from chamber 38 via flowline 60 to exhaust line 74. During this process, filtration bed 42 is regenerated. Inert gas, such as nitrogen, from flowline 54 is back flowed through bed 42 by pump 20, which also pulls a negative pressure on bed 42. As a result, the impurities adsorbed in the bed are desorbed, thus regenerating the bed. The desorbed impurities are exhausted from the bed via pump 20 through exhaust line 26. During this process, the F₂ gas supply would be filling pressure vessel 14, ready for the next cleaning process cycle.

It should be understood that the foregoing description is only illustrative of the present invention. Various alternatives and modifications can be devised by those skilled in the art without departing from the invention. Accordingly, the present invention is intended to embrace all such alternatives, modifications and variances.

## Claims

1. A method of removing residue from a surface of a semiconductor process chamber, the method comprising the steps of:
(a) storing a gas at sub-atmospheric pressure in a storage vessel;
(b) removing said gas from said storage vessel under a vacuum; and
(c) passing said gas through a process chamber to be cleaned.

2. A method according to claim 1, wherein said gas is passed through the process chamber via a remote plasma source for activating the gas.

3. A method according to claim 1 or claim 2, wherein said gas is selected from the group consisting of: fluorine, chlorine, ClFx, BrFx, O₂, O₃, NF₃, and any combinations thereof.

4. A method according to any preceding claim, wherein said gas is fluorine.

5. A method according to any preceding claim, wherein said storage vessel has a volume about 4 litres to about 8 litres.

6. A method according to any preceding claim, wherein said gas is stored in said storage vessel at a pressure in the range of about 0.133 mbar (1 torr) to about 1 bar (750 torr).

7. A method according to any preceding claim, wherein said process chamber is a CVD process chamber.

8. A method according to claim 7, wherein said CVD process chamber is used for depositing a material selected from the group consisting of: SiO₂, SiNx, W, WSi, Tin, TaN, low-K dielectric coatings, high-K dielectric coatings, Si-based photoresists, carbon-based photoresists, and any combinations thereof.

9. A method according to any preceding claim, comprising, prior to step (b), the step of passing inert gas through a motor housing of a vacuum pump used to remove the gas from said storage vessel.

10. A method according to claim 9, wherein said inert gas is selected from the group consisting of: argon, helium, nitrogen, oxygen, dry air, and any combinations thereof.

11. A method according to claim 9 or claim 10, wherein said inert gas is argon.

12. A method according to any of claims 9 to 11, wherein said inert gas is flowed to said motor housing at a flow rate of at least 1 standard litre/minute.

13. A method according to any proceeding claim, further comprising, after step (b), the step of passing said cleaning gas through at least one filtration bed.

14. A method according to claim 13, wherein said filtration bed comprises at least one filtration media selected from the group consisting of: CFx pellets, NaF, KF, CaF₂, NaHF₂, NaF(HF)y, KF(HF)y, CaF₂(HF)y, and any combinations thereof.

15. A method according to claim 13 or claim 14, comprising, after step (c), the step of returning said gas from said chamber back to said at least one filtration bed for reuse in the cleaning process.

16. A method according to claim 15, wherein the cleaning gas in said storage vessel is adjusted initially to a high concentration, with the recycled gas making up a greater volume of the gas passing through said filtration bed.

17. A system for removing residue from a surface of a semiconductor process chamber, said system comprising:
means for strong at sub-atmospheric pressure a gas for cleaning a process chamber; and
pump means for drawing said gas from said storage means under a vacuum.

18. A system according to claim 17, comprising a plasma source for activating the gas prior to its entry into the chamber.

19. A system according to claim 17 or claim 18, comprising means for passing inert gas through a motor housing of said vacuum pump.

20. A system according to any of claim 17 to 19, comprising means for purifying gas drawn from said storage means by said pump.

21. A system according to claim 20, wherein said purifying means comprises at least one filtration bed.

22. A system according to claim 21, wherein said filtration bed comprises at least one filtration media selected from the group consisting of: CFx pellets, NaF, KF, CaF₂, NaHF₂, NaF(HF)y, KF(HF)y, CaF₂(HF)y, and any combinations thereof.

23. A system according to any of claims 20 to 22, comprising means for returning said gas to said purifying means from said chamber.

24. A system according to any of claims 17 to 23, comprising means for controlling the flow of gas to said chamber
